# FASCICULE DE BREVET EUROPEEN

(11) **EP 2 137 769 B1**
(45) Date de publication et mention de la délivrance du brevet: **21.02.2018**
(21) Numéro de dépôt: 08788201.5
(22) Date de dépôt: 18.04.2008
(51) Int. Cl.: H02S 20/23, F24J 2/46, F24J 2/52

(54) **STRUCTURE POUR LE MONTAGE DANS UNE PAROI D'UN BÂTIMENT DE BÂTIS DESTINÉS À SUPPORTER DES PANNEAUX TELS QUE DES PANNEAUX PHOTOVOLTAÏQUES**
STRUKTUR ZUR MONTAGE VON RAHMEN ZUR AUFNAHME VON PANEELE, Z.B. PHOTOVOLTAISCHER PANEELE, AN GEBÄUDEWÄNDEN
STRUCTURE FOR MOUNTING ON A BUILDING WALL FRAMES FOR HOLDING PANELS SUCH AS PHOTOVOLTAIC PANELS

(30) Priorité: 20.04.2007 FR 0754606
(43) Date de publication de la demande: 30.12.2009
(73) Titulaire: Reyal, Jean-Pierre, 95610 Eragny (FR); Solarte, 66500 Ria Sirach (FR)
(72) Inventeur: REYAL, Jean-Pierre, 95610 Eragny (FR); JAUTARD, Yves, 66820 Vernet Les Bains (FR)
(74) Mandataire: Benech, Frédéric
(86) Numéro de dépôt international: PCT/FR2008/050699
(87) Numéro de publication internationale: WO 2008/145913

(56) Documents cités:
- EP-A- 0 949 686
- EP-A- 1 341 240
- WO-A-00/12839
- DE-U1- 20 304 676
- JP-A- 8 312 088
- JP-A- 10 122 125
- US-A- 6 065 255

## Description

La présente invention est relative à une structure pour le montage d'un bâti support de panneau sur la paroi d'un bâtiment tel qu'un pan de toit. La structure s'applique plus particulièrement au montage de bâti destiné à supporter des panneaux photovoltaïques.

Afin d'équiper les bâtiments, telles que des maisons, de générateurs d'électricité utilisant l'énergie solaire, on dispose, par exemple sur le toit de ces bâtiments, des ensembles de panneaux constitués d'une pluralité de cellules photovoltaïques.

Ces panneaux sont constitués en général d'un empilage de diverses couches de verre, de silicium, de conducteurs et de polymères. Les cellules de silicium, généralement carrées, ont une dimension pouvant atteindre 200 mm de côté. Les cellules sont assemblées en série puis collées entre deux feuilles de verre ou entre une feuille de verre et diverses couches de polymère. A titre d'exemple, un module de tension nominale 12 V est généralement composé par la mise en série de 36 cellules mono cristallines ou poly cristallines. Ces assemblages de 36 cellules sont ensuite assemblés en parallèle. Dans le cas d'un module de 24 V, on utilise alors 72 cellules de silicium. De tels panneaux peuvent atteindre des dimensions importantes de l'ordre de 1 mètre sur 2 mètres.

Pour monter les panneaux photovoltaïques sur les parois des bâtiments, on utilise des bâtis supports et par exemple des bâtis supports comportant un cadre périphérique constitué par exemple d'une structure creuse obtenue par pliage d'une bande métallique. Mais, ces bâtis doivent être fixés sur des parois des bâtiments de façon à maintenir les panneaux en place et de façon à pouvoir résister aux efforts résultant des intempéries. En particulier, la fixation des panneaux doit pouvoir résister au poids de la neige ou aux efforts d'arrachement résultant d'un vent important.

Habituellement, de tels bâtis sont disposés au-dessus des toits des bâtiments, ce qui présente notamment l'inconvénient d'être peu esthétiques. En outre, l'espace situé entre les panneaux et le toit peut être colmaté par exemple par des déchets telles que des feuilles mortes. Une structure pour le montage d'un bâti support de panneaux photovoltaïques est connue du document US-A-6065255. Le but de la présente invention est de remédier à ces inconvénients en proposant un moyen de fixer sur la paroi d'un bâtiment, tel qu'un toit ou tel qu'une façade, des bâtis supportant des panneaux, et notamment des panneaux électriquement actifs tels que des panneaux photovoltaïques, qui permette d'insérer l'ensemble constitué par les panneaux dans le toit ou la façade du bâtiment. A cet effet, l'invention a pour objet une structure pour le montage dans une paroi d'un bâtiment, d'au moins un bâti constitué d'un cadre rectangulaire. Elle comprend une armature constituée d'au moins deux montants et au moins deux traverses, assemblés de façon à former au moins un châssis rectangulaire adapté pour recevoir un bâti et des moyens de fixation d'au moins un bâti sur l'armature, chaque montant ayant une âme centrale bordée par deux ailes latérales comportant des échancrures prévues pour recevoir les traverses, chaque traverse ayant une âme centrale et des ailes latérales comportant des échancrures prévues pour venir au droit des montants aux intersections entre les traverses et les montants, de telle sorte que les ailes des montants et des traverses, qui s'étendent à la périphérie interne du châssis rectangulaire, forment une bordure en saillie sur laquelle un bâti peut venir s'emboîter.

De préférence, l'âme d'un montant comporte au moins une gouttière s'étendant sur toute la longueur du montant.

La gouttière peut être délimitée au moins par une nervure s'étendant sur toute la longueur du montant.

De préférence, l'âme d'une traverse comporte au moins une ouverture prévue pour déboucher au-dessus de la gouttière d'un montant sur lequel la traverse repose.

De préférence, l'âme d'une traverse est conformée de façon à présenter, dans sa partie axiale, au moins dans la zone d'intersection avec un montant, une surface d'appui en saillie dans la même direction que les ailes.

Une aile latérale d'une traverse peut être inclinée vers l'intérieur de la traverse de façon à permettre l'accrochage d'un bâti supporté par la structure.

Les moyens de fixation d'au moins un bâti sur l'armature comprennent par exemple des dispositifs d'ancrage et des parecloses de fixation retenues par les dispositifs d'ancrage et s'étendant au-dessus des montants, les dispositifs d'ancrage et les parecloses de fixation étant prévus pour que les parecloses de fixation viennent en appui au moins sur la face supérieure d'un bord d'un bâti.

Au moins un moyen de fixation peut comprendre à sa partie supérieure une tête de verrouillage, et la pareclose de fixation comporte alors une patte de blocage adaptée pour se clipser sur la tête de verrouillage.

Au moins un moyen de fixation peut comprendre à sa partie supérieure une tête de vissage, et la pareclose de fixation comporte à une de ses extrémités une palette de vissage adaptée pour être fixée au moyen d'une vis sur la tête de vissage et, à l'autre extrémité, une palette de recouvrement comprenant une patte de clipsage adaptée pour se clipser sur une palette de vissage.

Le moyen de fixation est constitué par exemple d'un corps de vissage comprenant une tige filetée distale pour vissage dans un élément de structure de la paroi d'un bâtiment et une tige filetée proximale séparée de la tige filetée distale par un moyen d'entraînement du corps de vissage, et d'une entretoise adaptée pour être vissée sur la tige filetée proximale du corps de vissage, l'entretoise comprenant une tête de verrouillage ou de vissage.

De préférence, les parecloses de fixation sont adaptées pour s'étendre de part et d'autre d'une zone de séparation de deux bâtis adjacents, de façon à assurer un recouvrement étanche de la zone de séparation des bâtis.

L'invention concerne également une paroi d'un bâtiment comportant une structure selon l'invention.

La paroi peut constituer un pan de toiture et comporter des poutres parallèles, les montants de la structure s'étendant le long des poutres parallèles et étant fixés sur celles-ci.

La paroi peut comprendre, en outre des bacs, notamment des bacs en matière plastique, en bois, en lamellé collé, en contreplaqué, en métal, ou pouvant comporter des doubles-vitrages, ou en matériau multicouche isolant, fixés sur les poutres parallèles sous la structure.

La paroi comprend par exemple au moins un panneau de cellules photovoltaïques fixé sur un bâti par la structure.

L'invention va maintenant être décrite de façon plus précise mais non limitative en regard des figures annexées, dans lesquelles :
- la figure 1 est une vue en perspective d'une portion de structure pour le montage dans le toit d'un bâtiment de bâtis destinés à supporter des panneaux électriquement actif ;
- la figure 2 est une vue agrandie en perspective de la zone de croisement d'un montant et d'une traverse d'une armature appartenant à une structure pour le montage de bâtis de support de panneaux dans un toit ;
- la figure 3 est une vue en perspective de la structure de la figure 1, dans laquelle un bâti est implanté ;
- la figure 4 est une vue en perspective de la structure, représentée à la figure 1, dans laquelle sont montés quatre bâtis qui supportent chacun un panneau ;
- les figures 5 et 6 sont deux vues en perspective d'une pareclose de fixation de bâti sur la structure de support de bâti ;
- la figure 7 est une vue en coupe des moyens de fixation d'un bâti sur l'armature de la figure 1 dans une zone de jonction entre deux bâtis adjacents ;
- la figure 8 est une vue en perspective d'un bâti support d'un panneau pouvant être monté sur la structure de la figure 1 ;
- la figure 9 est une vue en coupe de la zone de jonction entre deux bâtis adjacents.

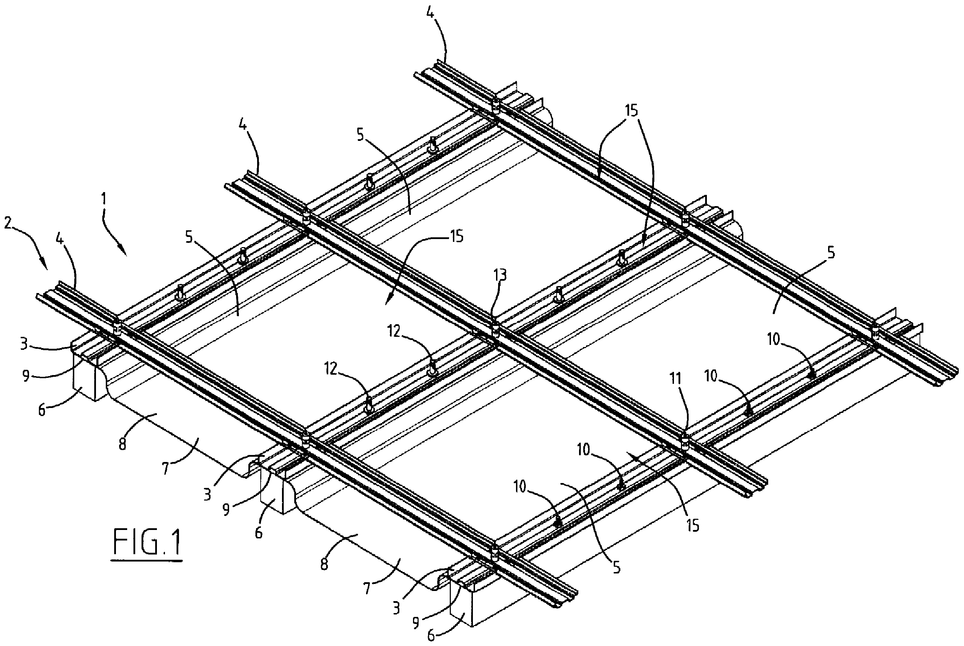

La structure, représentée généralement par 1 à la figure 1, est constituée d'une armature repérée généralement par 2, qui est constituée de montants 3 et de traverses 4, disposés de façon à former un treillis à mailles rectangulaires 5. Les montants 3 s'étendent le long des chevrons 6 de la charpente d'un toit, chaque montant 3 étant fixé sur un chevron.

L'espace 7 entre deux chevrons adjacents est occulté par un bac métallique 8 dont les rives 9 reposent sur les chevrons 6 et sont maintenus en position par les montants 3.

Les bacs métalliques 8 sont constitués par exemple d'un matériau multi-couches isolant constitué d'une âme en polymère enserrée entre deux feuilles métalliques, par exemple des feuilles métalliques en acier inoxydable ou des feuilles métalliques en acier galvanisé, ou éventuellement en acier galvanisé et laqué.

Ces bacs métalliques 8 sont destinés d'une part à assurer une certaine étanchéité sous des panneaux fixés sur l'armature 2, et d'autre part à assurer une isolation thermique lorsque les panneaux fixés sur l'armature 2 sont des panneaux soumis au rayonnement solaire, et donc peuvent s'échauffer et par conséquent chauffer l'atmosphère sous leur face inférieure.

Ces bacs peuvent être constitués d'autres matériaux tels que des matières plastiques, du bois, du lamellé collé ou du contreplaqué.

Dans le cas de verrières, les bacs peuvent être constitués d'un double vitrage.

Les montants 3 sont fixés sur les chevrons par les moyens de fixation 10 disposés entre deux traverses 11 disposés à la jonction d'une traverse et d'un montant.

Les moyens de fixation 10 et 11 comportent des corps vissés dans les chevrons 6 et sur lesquels peuvent être également vissés des entretoises 12 et 13 destinées à retenir des moyens pour fixer des bâtis sur l'armature. Ces moyens de fixation et ces entretoises seront décrits plus en détail ultérieurement.

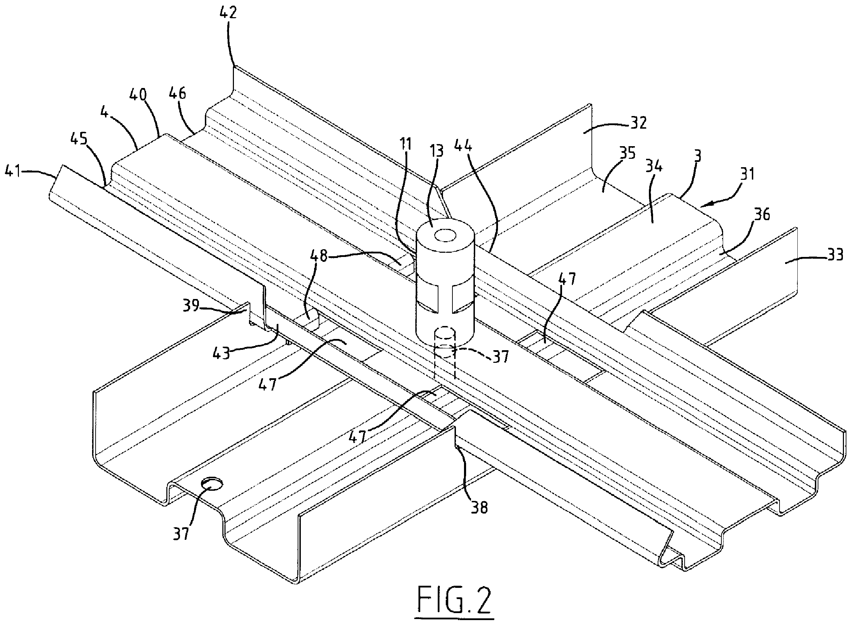

Comme on le voit de façon plus aisée à la figure 2, un montant 3 est un profilé qui comporte une âme centrale 31 bordée par deux ailes verticales 32 et 33. L'âme centrale 31 comprend une nervure centrale 34 en saillie vers le haut du montant, c'est-à-dire dans la direction dans laquelle s'étendent les deux ailes latérales 32 et 33. La nervure centrale 34 est délimitée par deux nervures latérales 35 et 36 s'étendant dans le sens opposé à la nervure centrale. Ces deux nervures latérales 35 et 36 également délimitée par les ailes latérales 32 et 33 respectivement constituent des gouttières permettant l'écoulement d'eau pouvant résulter de l'infiltration d'eau de pluie. La nervure centrale 34 en saillie vers le haut, comporte des trous 37 destinées à recevoir des moyens de fixation. Ces trous étant disposés sur la partie supérieure de la nervure centrale 34, l'eau qui peut s'écouler dans les gouttières 35 et 36 ne peut pas pénétrer à travers les trous 37. Les ailes latérales 32 et 33 comportent des échancrures 38 et 39, destinées à recevoir des traverses 4 dans les zones de jonction entre les montants et les traverses. Ces échancrures sont régulièrement espacées le long des montants à des distances adaptées pour que les mailles 5 délimitées par les montants et les traverses puissent recevoir des bâtis.

La traverse 4, perpendiculaire au montant 3, est également un profilé comprenant une âme centrale 40 bordée par deux ailes latérales 41 et 42. Les ailes latérales 41 et 42 comportent des échancrures 43 et 44 disposées dans la zone de jonction d'une traverse et d'un montant. L'âme centrale de la traverse 40 est conformée de façon à présenter deux nervures 45 et 46 en saillie sur la partie inférieure de la traverse et destinées à former des gouttières pour recevoir l'eau qui serait susceptible de s'infiltrer sous des panneaux supportés par l'armature ou les eaux de condensation. Les deux nervures 45 et 46 formant des gouttières comportent des ouvertures 47 constituées par des crevés situés au-dessus des gouttières 35 et 36 d'un montant dans la zone de jonction de la traverse 4 du montant 3. Ces ouvertures sont destinées à permettre l'écoulement de l'eau récupérée dans les gouttières 45 et 46 de la traverse pour la faire s'écouler dans les gouttières 35 et 36 des montants qui sont orientés dans le sens des chevrons de la charpente d'un toit. Les crevés 47 comportent des languettes 48 en saillie sous la face inférieure de la traverse pouvant s'encastrer dans le montant afin de bloquer la traverse par rapport au montant et d'en assurer un assemblage orthogonal.

A la jonction de la traverse 4 et du montant 3, la traverse est fixée sur le montant par l'intermédiaire d'un moyen de fixation 11 comportant une entretoise 13 qui sert d'écrou et qui permet de serrer la traverse 4 contre le montant 3. Ce moyen de fixation sera décrit plus en détail ultérieurement.

L'aile 42 de la traverse 4 destinée à être disposée dans la partie amont de l'armature est perpendiculaire à l'âme 40 de la traverse 4. L'aile 41 est située dans la partie aval de l'armature et est inclinée vers l'intérieur de la traverse 4.

Du fait de la disposition des échancrures 43, 44 prévues dans les ailes 41, 42 de la traverse, ainsi que, compte tenu du fait que les ailes 32 et 33 du montant s'élèvent à une hauteur suffisante pour s'étendre au-dessus de l'âme des traverses 4, les ailes latérales des montants et des traverses constituent une bordure en saillie vers le haut qui s'étend à la périphérie interne de chaque maille 5. Ainsi, chaque maille 5 délimitée par deux montants adjacents et deux traverses adjacentes constitue un châssis 15 sur lequel on peut venir disposer un bâti support d'un panneau.

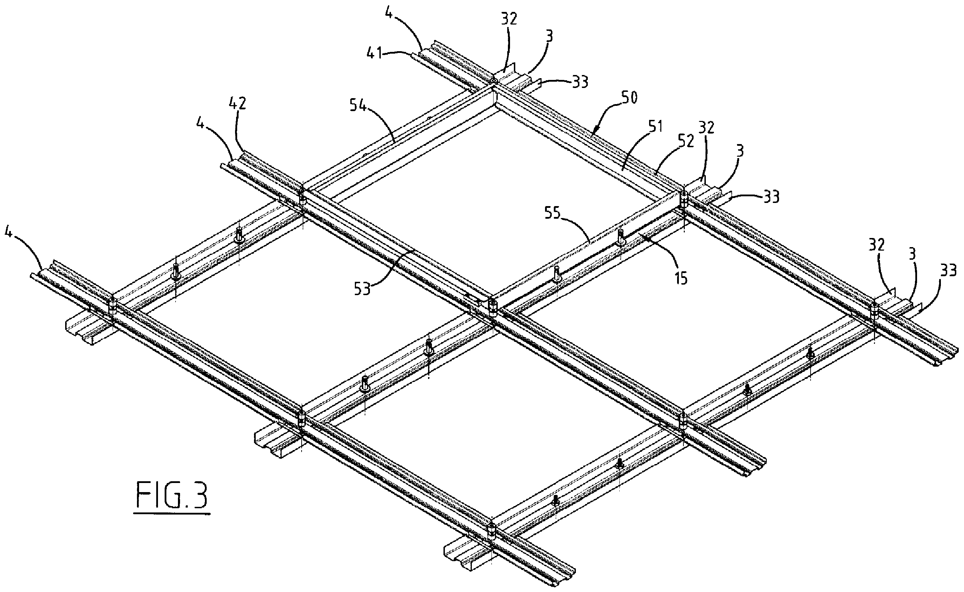

Comme on voit à la figure 3, un bâti, repéré généralement par 50 et destiné à recevoir un panneau (non présent sur la figure), est constitué d'un cadre 51 comportant des montants d'extrémité 52 et 53 et des montants latéraux repérés 54 et 55, de section trapézoïdale. Ce bâti est emboîté sur la bordure en saillie qui s'étend à la périphérie interne de l'ouverture centrale d'un châssis 15. Le montant d'extrémité supérieure 52 s'emboîte le long de l'aile 41 d'une traverse 4 repliée vers l'intérieur et qui ainsi accroche le montant d'extrémité supérieur 51. Les trois autres montants 53, 54 et 55 viennent se placer parallèlement aux ailes latérales 32, 33 et 42 des différents montants et traverses qui constituent le châssis.

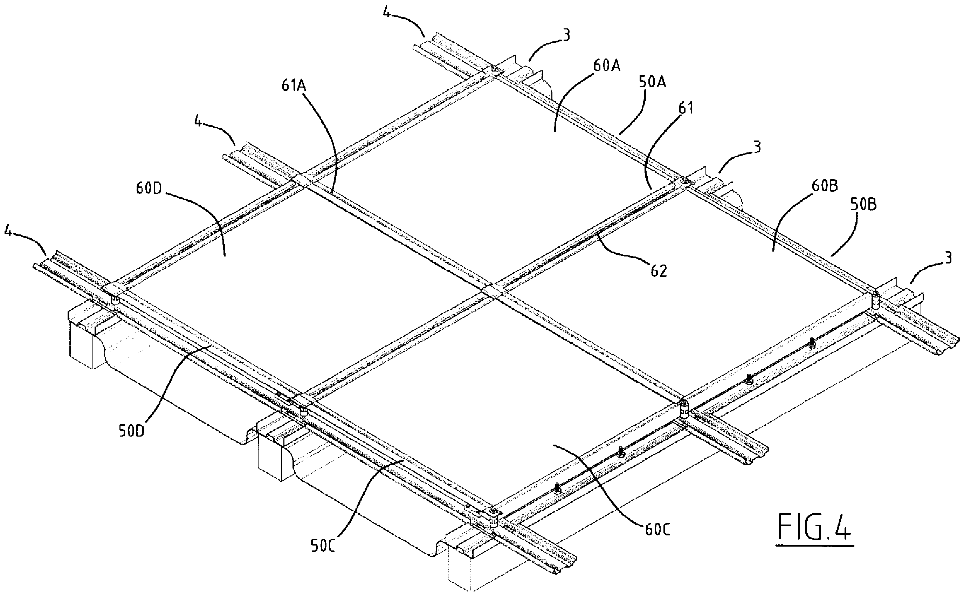

A la figure 4, on a représenté quatre bâtis 50A, 50B, 50C, 50D, qui portent des panneaux 60A, 60B, 60C, 60D respectivement montés sur la structure constituée par les montants 3 et les traverses 4, disposés de façon à former un pavage rectangulaire.

Deux bâtis adjacents 50A et 50B disposés horizontalement l'un à côté de l'autre, parallèlement aux traverses 4 sont séparés par un espace ou zone de séparation 61 qui s'étend au-dessus d'un montant 3. Cette zone de séparation 61 est recouverte par une pareclose de fixation 62 qui est retenue par les dispositifs d'encrage 10 et 11 disposés le long du montant 3.

Chaque pareclose de fixation a une longueur légèrement supérieure à la longueur d'un côté d'un cadre 50A ou 50B, et tous les espaces situés entre deux cadres adjacents et s'étendant parallèlement à des montants 3 sont recouverts par des parecloses de fixation 62.

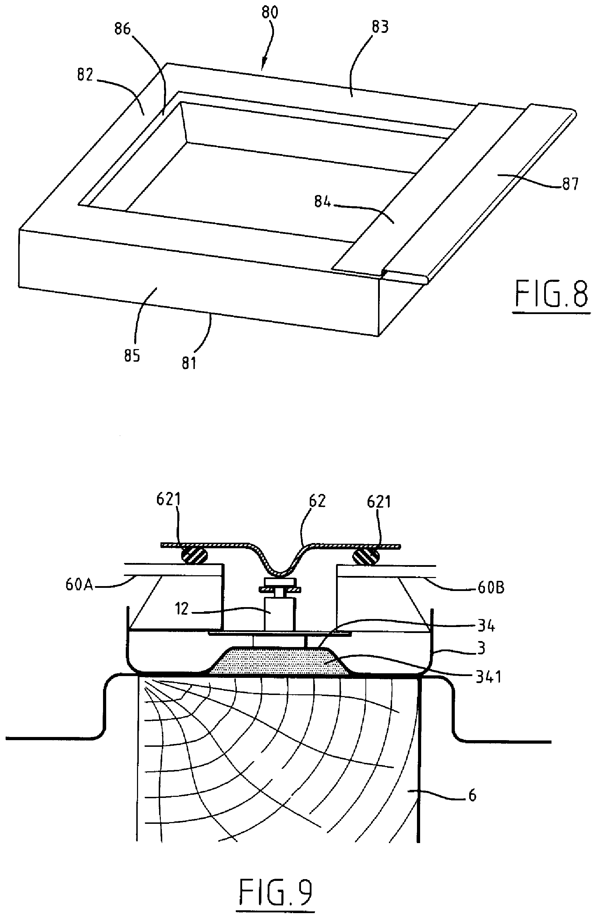

Comme cela est visible sur la figure 9, des joints élastomères souples 621 sont disposés entre les montants du bâti 60A et 60B.

Ainsi, une étanchéité est assurée le long des zones de jonction verticales de panneaux adjacents.

En outre, un joint rigide 341 comble l'espace compris entre la nervure centrale 34 du montant 3 et le chevron 6, afin d'éviter les phénomènes de condensation.

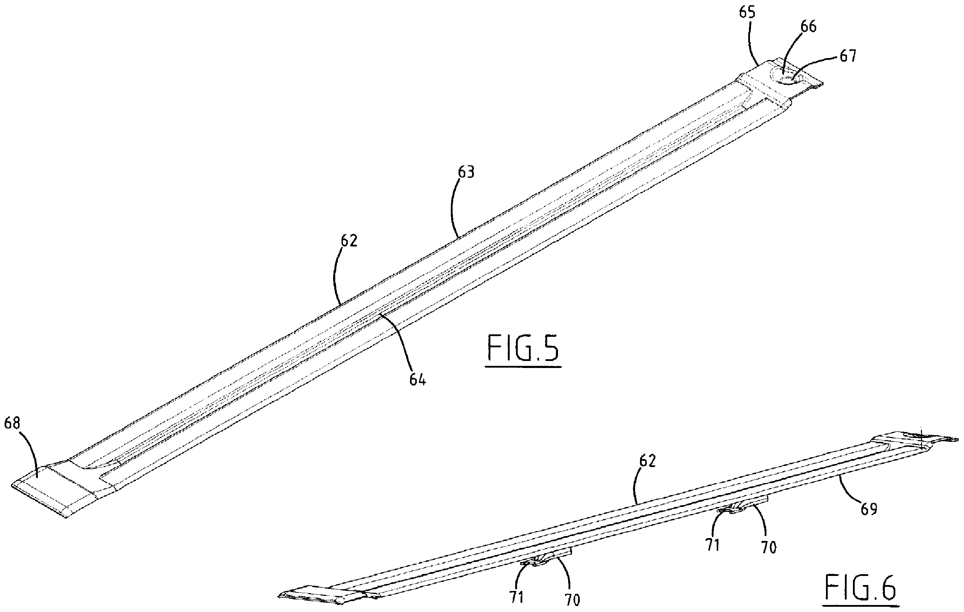

Une pareclose de fixation 62 est représentée plus en détail aux figures 5 et 6.

La pareclose de fixation, repérée généralement par 62 à la figure 5, comporte un corps longitudinal 63 comprenant une nervure centrale 64 destinée à assurer une bonne rigidité. Le corps 63 de la pareclose de fixation se termine à l'une de ses extrémités par une palette de vissage 65 comportant un logement 66 destiné à recevoir une tête de vis, le logement 66 comportant un trou central 67 destiné à faire passer le corps d'une vis.

L'autre extrémité de la pareclose de fixation 62 comporte une palette de recouvrement et de verrouillage 68, destinée à venir recouvrir la palette de vissage d'une pareclose de fixation adjacente.

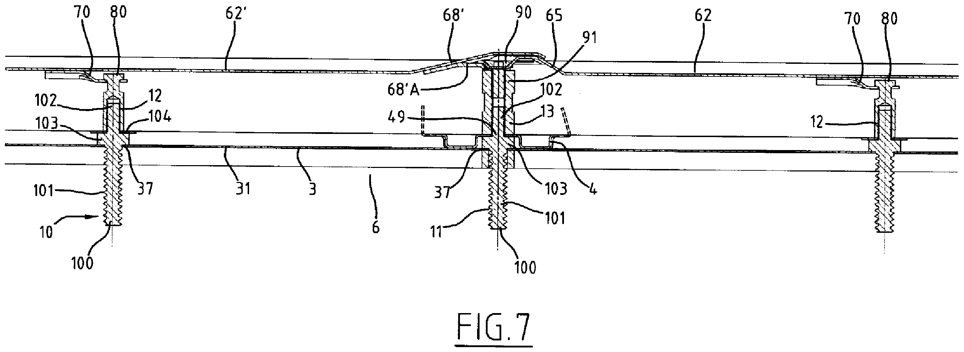

Comme on le voit sur la figure 6, la palette de fixation 62 comporte sur sa face inférieure 69 deux pattes de blocage 70 comportant des étriers 71 adaptés pour pouvoir se fixer par clipsage sur des têtes de verrouillage 80 d'entretoises 12 de moyens de fixation 10 d'un montant 3 sur une poutre 6 (ces moyens de fixation sont visibles sur la figure 7).

Comme on peut le voir également sur la figure 7, la palette de vissage 65 est fixée par l'intermédiaire d'une vis 90 qui vient se visser sur la tête de vissage 91 d'une entretoise 13 d'un moyen de fixation 11 d'un montant et d'une traverse situés au point de jonction du montant et de la traverse. Comme on voit sur la figure 7, la palette de verrouillage 68' d'une pareclose 62' venant en prolongement de la pareclose 62 vient recouvrir la palette de fixage 65 de la pareclose 62. La pareclose de recouvrement et de verrouillage 68' comporte à sa partie inférieure une patte 68'A qui vient se clipser sur l'extrémité de la palette de vissage 65 de l'autre pareclose. On notera que la pareclose 62 dont la palette de vissage est recouverte par la palette de recouvrement et de verrouillage 68' de la pareclose 62', est située en aval de la pareclose 62' par rapport à la pente du toit, de façon à assurer une bonne étanchéité. En effet, dans cette disposition, lorsque l'eau de pluie tombe sur le toit et qu'elle s'écoule, elle s'écoule dans le sens qui va de l'amont vers l'aval et donc à la jonction entre la pareclose 62' et la pareclose 62, l'eau de pluie s'écoule d'abord sur la pareclose 62', passe sur la palette de recouvrement 68' et vient s'écouler ensuite sur le corps de la pareclose 62. Ainsi, l'eau de pluie ne pénètre pas dans les trous correspondants au passage de la vis de fixation 90.

Les moyens de fixation 10 et 11, comportent chacun un corps de vissage 100 comprenant une tige filetée distale 101 qui vient se visser dans le chevron 6 et une tige de vissage proximale 102 sur laquelle viennent se fixer par vissage une entretoise 12 ou 13.

Lorsque le moyen de fixation est un moyen de fixation 10 disposé entre deux traverses, l'entretoise 12 comporte une tête de verrouillage 80.

Lorsque le moyen de fixation est un moyen de fixation 11 disposé à la jonction d'une traverse et d'un montant, l'entretoise 13 comporte une tête de vissage 91.

Les tiges de vissage proximale et distale 101 et 102 sont séparées par un moyen d'entraînement en rotation 103 qui est constitué comme une tête de vissage à six pans.

On notera que les corps de vissage 100 sont vissés dans les chevrons 6 en passant à travers les trous 37 prévus dans l'âme du montant 3, de telle sorte que les têtes d'entraînement 103 des corps de vissage 100 viennent en appui sur la face supérieure de la nervure centrale 31 du montant 3. Dans la zone de jonction entre un montant 3 et une traverse 4, la traverse 4 est alors emmanchée sur la partie proximale 102 du corps de vissage 100 qui passe à travers un trou 49 prévu dans l'âme de la traverse. Une tête de vissage 91 destinée à recevoir la vis 90 de fixation de la palette de vissage 65 de la pareclose de fixation 62 est vissée sur la tige de vissage proximale 102 et vient ainsi serrer la traverse contre la tête de vissage 103.

Dans les zones situées entre deux traverses, une entretoise 12 comportant une tête de verrouillage 80 est vissée directement sur la tige proximale de vissage 102 du moyen de fixation 10. En outre, une rondelle 104 est disposée entre la tête d'entraînement 103 de la tige de vissage et l'entretoise 12 de façon à constituer une surface d'appui pour le montant latéral d'un cadre fixé sur l'armature. Cette rondelle a une épaisseur identique à l'épaisseur de la tôle qui constitue la traverse, de telle sorte que la face supérieure de la rondelle est au même niveau que la face supérieure de l'âme d'une traverse. Ainsi, le cadre est en appui plan sur ses quatre côtés.

Comme on l'a indiqué, l'étanchéité entre deux cadres adjacents est assurée par des parecloses de fixation qui assurent à la fois l'étanchéité et la fixation des bâtis sur la structure support. En revanche, l'étanchéité entre deux bâtis adjacents 50A et 50D disposés en colonne parallèlement à des chevrons, est assurée par l'intermédiaire d'une aile latérale 61A prévue sur le montant du bâti 50A disposé vers l'aval. Cette aile 61A qui s'étend vers l'extérieur du bâti 50A vient en recouvrement du montant du bâti 50D situé en aval par rapport au bâti 50A. Ce recouvrement assure une étanchéité de la même façon que les tuiles d'un toit qui se recouvrent d'une autre.

Un bâti adapté pour cette utilisation est représenté à la figure 8. Ce bâti 80 est constitué d'une structure périphérique 81 comportant quatre montants 82, 83, 84 et 85. Les quatre montants comportent, à leur partie supérieure interne, une gorge 86 destinée à recevoir un panneau. Un montant 84 comporte une aile latérale 87 s'étendant vers l'extérieur à la partie supérieure du cadre et à une hauteur suffisante pour pouvoir s'adapter sur le montant opposé d'un cadre adjacent.

Les cadres qui viennent d'être décrits peuvent être fabriqués par pliage d'une ou de plusieurs bandes métalliques qui sont découpées de façon adaptée, puis pliées et enfin assemblées par soudage. Ce mode de fabrication permet d'obtenir des cadres particulièrement légers et rigides. En outre, ils sont creux. Ainsi, lorsqu'ils sont destinés à recevoir des panneaux électriquement actifs tels que des panneaux photovoltaïques, les circuits de liaison électrique des panneaux entre eux et avec un circuit extérieur, peuvent être dissimulés à l'intérieur des montants creux.

La structure qui vient d'être décrite peut être utilisée notamment pour implanter des panneaux photovoltaïques dans une toiture de bâtiment. Dans ce cas, la structure étant directement montée sur les chevrons, l'ensemble des panneaux photovoltaïques est intégré à la toiture. Des moyens connus en eux-mêmes sont prévus pour assurer l'étanchéité entre la toiture elle-même et les panneaux de cellules photovoltaïques, de façon à ce que la pluie ne pénètre pas sous les panneaux à la jonction entre la toiture et les panneaux photovoltaïques.

Une telle structure peut également être utilisée pour fixer des panneaux photovoltaïques ou plus généralement des panneaux électriquement actifs sur une paroi de bâtiment tel qu'un mur qui peut être vertical. Dans ce cas, les montants sont fixés sur la structure de la paroi. Cette structure de la paroi peut être constituée de poutres ou de béton dans laquelle on peut visser les moyens de fixation des montants.

## Revendications

1. Structure (1) pour le montage sur une paroi d'un bâtiment, d'au moins un bâti (50, 80) support d'un panneau, ledit bâti (50, 80) étant constitué d'un cadre rectangulaire (51), **caractérisée en ce qu'**elle comprend une armature (2) constituée d'au moins deux montants (3) et au moins deux traverses (4), assemblés de façon à former au moins un châssis rectangulaire (15) adapté pour recevoir ledit bâti (50) et des moyens de fixation d'au moins un bâti sur l'armature, chaque montant (3) ayant une âme centrale (31) bordée par deux ailes latérales (32, 33) comportant des échancrures (38, 39) recevant les traverses (4), chaque traverse (4) ayant une âme centrale (40) et des ailes latérales (41, 42) comportant des échancrures (43, 44) venant au droit des montants (3) aux intersections entre les traverses (4) et les montants (3), de telle sorte que les ailes (32, 33, 41, 42) des montants (3) et des traverses (4), qui s'étendent à la périphérie interne du châssis rectangulaire (15) forment une bordure en saillie sur laquelle ledit bâti (50) peut venir s'emboîter.

2. Structure selon la revendication 1, **caractérisée en ce que** l'âme (31) d'un montant (3) comporte une nervure centrale (34) en saillie vers le haut du montant (3), ladite nervure centrale (34) s'étendant sur toute la longueur du montant (3), et étant délimitée par deux nervures latérales (35, 36) s'étendant dans le sens opposé à la nervure centrale, les nervures latérales (35, 36) étant délimitées par la nervure centrale (34) et par les ailes latérales (32, 33) du montant (3) et constituant des gouttières (35, 36) s'étendant sur toute la longueur du montant.

3. Structure selon la revendication 2, **caractérisée en ce que** l'âme (40) d'une traverse (4) comporte au moins une ouverture (47) débouchant au-dessus de la gouttière (35, 36) d'un montant (3) sur lequel la traverse (4) repose.

4. Structure selon l'une quelconque des revendications 1 à 3, **caractérisée en ce que** une aile latérale (41) d'une traverse (4) est inclinée vers l'intérieur de la traverse de façon à permettre l'accrochage d'un bâti supporté par la structure.

5. Structure selon l'une quelconque des revendications 1 à 4, **caractérisée en ce que** les moyens de fixation d'au moins un bâti sur l'armature comprennent des dispositifs d'ancrage (10, 11) et des parecloses (62) de fixation retenues par les dispositifs d'ancrage (10, 11) et s'étendant au-dessus des montants (3), les dispositifs d'ancrage (10, 11) et les parecloses de fixation (62) étant prévus pour que les parecloses de fixation (62) viennent en appui au moins sur la face supérieure d'un bord d'un bâti (50A, 50B).

6. Structure selon la revendication 5, **caractérisée en ce qu'**au moins un moyen de fixation (10) comprend à sa partie supérieure une tête de verrouillage (80), et **en ce que** la pareclose de fixation (62) comporte une patte de blocage (70) adaptée pour se clipser sur la tête de verrouillage (80).

7. Structure selon la revendication 5, **caractérisée en ce qu'**au moins un moyen de fixation (11) comprend à sa partie supérieure une tête de vissage (91), et **en ce que** la pareclose de fixation (62) comporte à une de ses extrémités une palette de vissage (65) adaptée pour être fixée au moyen d'une vis (90) sur la tête de vissage, et **en ce que** la pareclose de fixation (62)comporte, à l'autre extrémité, une palette de recouvrement (68) comprenant une patte de clipsage adaptée pour se clipser sur une palette de vissage.

8. Structure selon la revendication 6 ou la revendication 7, **caractérisée en ce que** le moyen de fixation (10, 11) est constitué d'un corps de vissage (100) comprenant une tige filetée distale (101) pour vissage dans un élément de structure de la paroi d'un bâtiment et une tige filetée proximale (102) séparée de la tige filetée distale par un moyen d'entraînement (103) du corps de vissage, et d'une entretoise (12, 13) adaptée pour être vissée sur la tige filetée proximale du corps de vissage, l'entretoise (12, 13) comprenant une tête de verrouillage (80) ou une tête de vissage (91).

9. Structure selon l'une quelconque des revendications 5 à 8, **caractérisée en ce que** les parecloses de fixation (62) sont adaptées pour s'étendre de part et d'autre d'une zone de séparation (61) de deux bâtis adjacents (50A, 50B), de façon à assurer un recouvrement étanche de la zone de séparation des bâtis.

10. Paroi de bâtiment **caractérisée en ce qu'**elle constitue un pan de toiture, **en ce qu'**elle comporte des poutres parallèles (6), et **en ce qu'**elle comporte une structure selon l'une quelconque des revendications 1 à 9, les montants (3) de la structure s'étendant le long des poutres parallèles (6) et étant fixés sur les poutres parallèles (6).

11. Paroi de bâtiment selon la revendication 10, **caractérisée en ce qu'**elle comprend, en outre des bacs (8) fixés sur les poutres parallèles (6) sous la structure (1).

12. Paroi de bâtiment selon la revendication 11, **caractérisée en ce que** les bacs sont des bacs en matière plastique ou en bois en lamellé collé ou en contreplaqué, ou des bacs métalliques en matériau multicouche isolant, ou des doubles vitrages.

13. Paroi de bâtiment selon l'une quelconque des revendications 10 à 11, **caractérisée en ce qu'**elle comprend au moins un bâti (50) emboîté sur ladite bordure en saillie et un panneau de cellules photovoltaïques supporté par le bâti (50).

## Patentansprüche

1. Struktur (1) zur Montage von mindestens einem Tragegestell (50, 80) für ein Paneel an einer Gebäudewand, wobei das Gestell (50, 80) durch einen rechteckigen Rahmen (51) gebildet ist,
**dadurch gekennzeichnet,**
**dass** sie ein Gerüst (2) umfasst, das durch mindestens zwei Ständer (3) und mindestens zwei Querstreben (4) gebildet ist, welche derart zusammengestellt sind,
**dass** mindestens ein rechteckiges Gestell (15) gebildet wird, das geeignet ist, um das Gestell (50) und Mittel zur Befestigung mindestens eines Gestells an dem Gerüst aufzunehmen, wobei jeder Ständer (3) einen mittigen Steg (31) mit zwei Seitenflügeln (32, 33) mit Aussparungen (38, 39) zur Aufnahme der Querstreben (4) aufweist, wobei jede Querstrebe (4) einen mittigen Steg (40) und Seitenflügel (41, 42) mit rechtwinklig zu den Ständern (3) an den Schnittstellen zwischen den Querstreben (4) und den Ständern (3) ausgebildeten Aussparungen (43, 44) aufweist, so dass die Flügel (32, 33, 41 , 42) der Ständer (3) und der Querstreben (4), die sich am Innenumfang des rechteckigen Gestells (15) erstrecken, einen überstehenden Rand bilden, auf den das Gestell (50) gesteckt werden kann.

2. Struktur nach Anspruch 1,
**dadurch gekennzeichnet,**
**dass** der Steg (31) eines Ständers (3) eine mittige Rippe (34) aufweist, die zum oberen Teil des Ständers (3) hin hervorragt, wobei die mittige Rippe (34) sich über die gesamte Länge des Ständers (3) erstreckt und durch zwei seitliche Rippen (35, 36) begrenzt ist, die sich in der entgegengesetzten Richtung zur mittigen Rippe erstrecken, wobei die seitlichen Rippen (35, 36) durch die mittige Rippe (34) und durch die Seitenflügel (32, 33) des Ständers (3) begrenzt sind und Rinnen (35, 36) bilden, die sich über die gesamte Länge des Ständers erstrecken.

3. Struktur nach Anspruch 2,
**dadurch gekennzeichnet,**
**dass** der Steg (40) einer Querstrebe (4) mindestens eine Öffnung (47) aufweist, die über der Rinne (35, 36) eines Ständers (3) mündet, auf dem die Querstrebe (4) aufliegt.

4. Struktur nach einem beliebigen der Ansprüche 1 bis 3,
**dadurch gekennzeichnet,**
**dass** ein Seitenflügel (41) einer Querstrebe (4) zum Inneren der Querstrebe geneigt ist, so dass ein von der Struktur getragenes Gestell eingehängt werden kann.

5. Struktur nach einem beliebigen der Ansprüche 1 bis 4,
**dadurch gekennzeichnet,**
**dass** die Mittel zur Befestigung mindestens eines Gestells am Gerüst Verankerungsvorrichtungen (10, 11) und Befestigungsleisten (62) aufweisen, die durch die Verankerungsvorrichtung (10, 11) festgehalten werden und sich über den Ständern (3) erstrecken, wobei die Verankerungsvorrichtungen (10, 11) und die Befestigungsleisten (62) vorgesehen sind, damit die Befestigungsleisten (62) mindestens auf die Oberseite eines Randes eines Gestells (50A, 50B) zur Anlage kommen.

6. Struktur nach Anspruch 5,
**dadurch gekennzeichnet,**
**dass** mindestens ein Befestigungsmittel (10) in seinem oberen Bereich einen Verriegelungskopf (80) aufweist und
**dass** die Befestigungsleiste (62) eine Sperrlasche (70) aufweist, die geeignet ist, um an dem Verriegelungskopf (80) einzurasten.

7. Struktur nach Anspruch 5,
**dadurch gekennzeichnet,**
**dass** mindestens ein Befestigungsmittel (11) in seinem oberen Teil einen Schraubkopf (91) aufweist und
**dass** die Befestigungsleiste (62) an einem ihrer Enden einen Schraubflügel (65) aufweist, der geeignet ist, um mittels einer Schraube (90) am Schraubkopf befestigt zu werden, und
**dass** die Befestigungsleiste (62) am anderen Ende einen Abdeckflügel (68) mit einer Rastlasche aufweist, die geeignet ist, um an einem Schraubflügel einzurasten.

8. Struktur nach Anspruch 6 oder nach Anspruch 7,
**dadurch gekennzeichnet,**
**dass** das Befestigungsmittel (10, 11) durch einen Schraubkörper (100) mit einem distalen Gewindestift (101) zum Verschrauben in einem Strukturelement der Wand eines Gebäudes und einem proximalen Gewindestift (102), der von dem distalen Gewindestift durch ein Mittel (103) für den Antrieb des Schraubkörpers getrennt ist, und durch eine Strebe (12, 13), die geeignet ist, um auf den proximalen Gewindestift des Schraubkörpers geschraubt zu werden, gebildet ist, wobei die Strebe (12, 13) einen Verriegelungskopf (80) oder einen Schraubkopf (91) aufweist.

9. Struktur nach einem beliebigen der Ansprüche 5 bis 8,
**dadurch gekennzeichnet,**
**dass** die Befestigungsleisten (62) geeignet sind, um sich beidseitig eines Bereichs (61) zur Trennung zweier angrenzender Gestelle (50A, 50B) so zu erstrecken, dass eine dichte Abdeckung des Bereichs zur Trennung der Gestelle sichergestellt ist.

10. Gebäudewand,
**dadurch gekennzeichnet,**
**dass** sie durch eine Dachfläche gebildet ist,
**dass** sie parallel verlaufende Balken (6) aufweist und dass sie eine Struktur gemäß einem beliebigen des Ansprüche 1 bis 9 aufweist, wobei die Ständer (3) der Struktur sich entlang der parallel verlaufenden Balken (6) erstrecken und an den parallel verlaufenden Balken (6) befestigt sind.

11. Gebäudewand nach Anspruch 10,
**dadurch gekennzeichnet,**
**dass** sie ferner Behälter (8) aufweist, die an den parallel verlaufenden Balken (6) unter der Struktur (1) befestigt sind.

12. Gebäudewand nach Anspruch 11,
**dadurch gekennzeichnet,**
**dass** es sich bei den Behältern um Behälter aus Kunststoff oder aus Brettschichtholz oder aus Sperrholz oder um metallische Behälter aus einem isolierenden Mehrschichtmaterial oder um Doppelverglasungen handelt.

13. Gebäudewand nach einem beliebigen der Ansprüche 10 bis 11,
**dadurch gekennzeichnet,**
**dass** sie mindestens ein Gestell (50), das auf den überstehenden Rand gesteckt ist, und ein Paneel aus photovoltaischen Zellen aufweist, das durch das Gestell (50) getragen wird.

## Claims

1. Structure (1) for mounting, on a building wall, at least one panel-supporting assembly (50, 80), said assembly (50, 80) consisting of a rectangular frame (51), **characterised in that** it comprises a framework (2) consisting of at least two uprights (3) and at least two crossbars (4), assembled so as to form at least one rectangular chassis (15) adapted to receive said assembly (50) and means for fixing at least one assembly to the framework, each upright (3) having a central core (31) bordered by two lateral wings (32, 33) comprising notches (38, 39) receiving the crossbars (4), each crossbar (4) having a central core (40) and lateral wings (41, 42) comprising notches (43, 44) which come opposite the uprights (3) at the intersections between the crossbars (4) and the uprights (3), so that the wings (32, 33, 41, 42) of the uprights (3) and crossbars (4), which extend at the internal periphery of the rectangular chassis (15), form a projecting border onto which said assembly (50) can fit.

2. Structure according to claim 1, **characterised in that** the core (31) of an upright (3) comprises a central rib (34) projecting towards the top of the upright (3), said central rib (34) extending over the whole length of the upright (3), and being delimited by two lateral ribs (35, 36) extending in the opposite direction to the central rib, the lateral ribs (35, 36) being delimited by the central rib (34) and by the lateral wings (32, 33) of the upright (3) and constituting gutters (35, 36) extending over the whole length of the upright.

3. Structure according to claim 2, **characterised in that** the core (40) of a crossbar (4) comprises at least one opening (47) which opens out above the gutter (35, 36) of an upright (3) on which the crossbar (4) rests.

4. Structure according to any one of claims 1 to 3, **characterised in that** a lateral wing (41) of a crossbar (4) is inclined towards the interior of the crossbar so as to allow an assembly supported by the structure to be hooked on.

5. Structure according to any one of claims 1 to 4, **characterised in that** the means for fixing at least one assembly to the framework comprise anchoring devices (10, 11) and fixing beads (62) retained by the anchoring devices (10, 11) and extending above the uprights (3), the anchoring devices (10, 11) and the fixing beads (62) being provided so that the fixing beads (62) come to rest at least on the upper face of an edge of an assembly (50A, 50B).

6. Structure according to claim 5, **characterised in that** at least one fixing means (10) comprises on its upper portion a locking head (80), and **in that** the fixing bead (62) comprises a locking lug (70) adapted to clip onto the locking head (80).

7. Structure according to claim 5, **characterised in that** at least one fixing means (11) comprises on its upper portion a screwing head (91), and **in that** the fixing bead (62) comprises at one of its ends a screwing vane (65) adapted to be fixed by means of at least one screw (90) to the screwing head, and **in that** the fixing bead (62) comprises, at the other end, a covering vane (68) comprising a clip-on foot adapted to clip onto a screwing vane.

8. Structure according to claim 6 or claim 7, **characterised in that** the fixing means (10, 11) consists of a screwing body (100) comprising a distal threaded rod (101) for screwing into a structural element of the building wall and a proximal threaded rod (102) separated from the distal threaded rod by a means (103) for driving the screwing body, and a strut (12, 13) adapted to be screwed onto the proximal threaded rod of the screwing body, the strut (12, 13) comprising a locking head (80) or a screwing head (91).

9. Structure according to any one of claims 5 to 8, **characterised in that** the fixing beads (62) are adapted to extend on either side of a zone (61) for separating two adjacent assemblies (50A, 50B), so as to ensure that the zone for separating the assemblies is covered in sealing relationship.

10. Building wall, **characterised in that** it constitutes a roof slope, **in that** it comprises parallel beams (6), and **in that** it comprises a structure according to any one of claims 1 to 9, the uprights (3) of the structure extending along the parallel beams (6) and being fixed to the parallel beams (6).

11. Building wall according to claim 10, **characterised in that** it further comprises trays (8) fixed to the parallel beams (6) underneath the structure (1).

12. Building wall according to claim 11, **characterised in that** the trays are trays made of plastic material or laminated wood or plywood, or metallic trays of multi-layer insulating material, or double glazing.

13. Building wall according to any one of claims 10 to 11, **characterised in that** it comprises at least one assembly (50) which fits onto said projecting border and a panel of photovoltaic cells supported by the assembly (50).
